# FASCICULE DE BREVET EUROPEEN

(11) **EP 3 086 374 B1**
(45) Date de publication et mention de la délivrance du brevet: **13.09.2017**
(21) Numéro de dépôt: 16166723.3
(22) Date de dépôt: 22.04.2016
(51) Int. Cl.: H01L 29/66, H01L 27/12, H01L 29/786, H01L 29/417, H01L 21/02, H01L 21/308, H01L 21/3105, H01L 21/762, H01L 21/28, H01L 29/06

(54) **PROCÉDÉ DE RÉALISATION D'UN DISPOSITIF À EFFET DE CHAMP AMÉLIORÉ**
HERSTELLUNGSVERFAHREN EINES VERBESSERTEN FELDEFFEKTTRANSITORS
METHOD FOR PRODUCING AN IMPROVED FIELD EFFECT TRANSISTOR

(30) Priorité: 23.04.2015 FR 1553636
(43) Date de publication de la demande: 26.10.2016
(73) Titulaire: Commissariat à l'Energie Atomique et aux Energies Alternatives, 75015 Paris (FR)
(72) Inventeur: Previtali, Bernard, 38100 Grenoble (FR)
(74) Mandataire: Talbot, Alexandre

(56) Documents cités:
- US-A1- 2006 027 881
- US-A1- 2011 241 073
- US-B1- 6 335 214
- LA TULIPE D C ET AL: "Upside-down FETS", 2008 IEEE INTERNATIONAL SOI CONFERENCE PROCEEDINGS, PISCATAWAY, NJ, USA, 6 octobre 2008 (2008-10-06), pages 23-24, XP031351836, ISBN: 978-1-4244-1954-8

## Description

### Domaine technique de l'invention

L'invention est relative à un procédé de réalisation d'un dispositif à effet de champ.

### État de la technique

L'augmentation continue des performances des circuits intégrés, par exemple, en termes de consommation et/ou de fréquence de fonctionnement, se traduit inéluctablement par une diminution constante de la taille de ses composants. Afin de réaliser des dispositifs toujours plus performants, de nouvelles architectures et/ou de nouveaux matériaux ont été intégrés dans les transistors.

Cependant, il apparaît que pour de nombreuses architectures, les capacités parasites prennent une place de plus en plus importante ce qui réduit les gains procurés par les autres améliorations. Une manière de réduire ces capacités parasites est de placer les contacts de source et de drain d'un côté du film en matériau semi-conducteur formant le canal de conduction et les zones de source/drain. L'électrode de grille est disposée de l'autre côté du film semi-conducteur ce qui réduit fortement la surface en regard entre l'électrode de grille est les contacts. Un exemple de réalisation est décrit dans le brevet US7915110. Cependant, il s'avère que ce procédé de fabrication est compliqué à réaliser car il nécessite d'amorphiser les futures zones de source et de drain et d'utiliser la différence de propriété optique entre les zones amorphes et les zones cristallines pour placer correctement des masques de protection.

Le document US 2013/0299897 décrit la réalisation d'un transistor inversé avec prise des contacts de source et de drain sur la face opposée à l'électrode de grille. Une électrode de grille est réalisée sur un substrat de type semi-conducteur sur isolant.

L'électrode de grille sert de masque de gravure pour graver la couche de semi-conducteur sur isolant, la couche d'isolant enterré puis une partie du substrat de support semi-conducteur.

Une épitaxie est réalisée à partir du substrat de support pour venir connecter le substrat de support avec la couche de semi-conducteur sur isolant. Les zones épitaxiées forment les zones de source et de drain. Un encapsulant est déposé et est collé à un deuxième substrat de support.

Le premier substrat de support est éliminé pour accéder à la couche d'isolant enterré et aux zones de source et de drain formées par épitaxie. Un nouvel encapsulant est déposé puis gravé pour former des contacts de source et de drain.

Ce document enseigne également de réaliser une deuxième électrode de grille en utilisant l'isolant enterré comme diélectrique de grille.

A la lecture de ce document on s'aperçoit aisément que la réalisation d'un tel dispositif est très difficile et que le dispositif final ne sera aussi performant qu'attendu. Le document US6335214-B1 décrit un procédé de formation d'un transistor à double grille sur un substrat de type semi-conducteur sur isolant (SOI).

### Objet de l'invention

L'invention a pour objet la réalisation d'un dispositif à effet de champ qui présente des performances électriques améliorées et qui soit plus facile à mettre en oeuvre. On tend à atteindre cet objectif au moyen d'un procédé selon les revendications annexées.

Le procédé selon l'invention est remarquable en ce qu'il comporte successivement :
- prévoir un substrat recouvert par
   ∘ un motif de partage,
   ∘ un motif en matériau semi-conducteur recouvrant le motif de partage, le motif de partage comportant au moins trois faces consécutives recouvertes par le motif en matériau semi-conducteur,
   ∘ un motif de grille recouvrant le motif de partage et le motif en matériau semi-conducteur de manière à définir une zone de source, une zone de drain et un canal de conduction dans le motif en matériau semi-conducteur,
- déposer une couche de couverture de manière à recouvrir le substrat, le motif en matériau semi-conducteur et le motif de grille,
- éliminer le substrat de manière à libérer une partie de la zone de source, de la zone de drain et du motif de grille,
- former deux motifs de délimitation recouvrant les zones de source et de drain et laissant libre le motif de partage,
- déposer une deuxième couche de couverture, les première et deuxième couches de couverture étant séparées par le motif en matériau semi-conducteur sur au moins une partie,
- éliminer les deux motifs de délimitation pour former des trous d'accès à la zone de source et à la zone de drain.

Dans un mode de réalisation particulier les motifs de délimitation sont formés par dépôt sélectif à partir des zones de source et de drain.

Il est également possible de prévoir une étape de polissage mécano-chimique de la deuxième couche de couverture configurée pour libérer les motifs de délimitation.

De manière avantageuse, le procédé qu'il comporte en outre la formation d'espaceurs latéraux sur les bords des motifs de délimitation.

Dans un mode de réalisation préférentiel, le procédé comporte la formation d'espaceurs latéraux sur les bords de la deuxième couche de couverture après élimination des motifs de délimitation. Plus particulièrement, les espaceurs latéraux additionnels sont formés sur les bords des espaceurs latéraux après élimination des motifs de délimitation. De manière avantageuse, un alliage est formé entre un métal et un matériau semi-conducteur formant les zones de source et de drain et les espaceurs latéraux additionnels sont réalisés après la formation de l'alliage.

Dans un mode de réalisation particulier, le motif de partage est gravé partiellement.

Dans un mode de réalisation plus précis, le procédé comporte successivement :
- l'élimination du motif de partage,
- la formation d'un diélectrique grille,
- le dépôt d'un matériau électriquement conducteur entre les deux motifs de délimitation pour former une électrode de grille.

Il est particulièrement avantageux de prévoir que l'espaceur latéral comporte au moins une couche en matériau ayant une constante diélectrique inférieure à celle de l'oxyde de silicium.

Il est encore possible de prévoir une étape de polissage mécano-chimique pour localiser le matériau électriquement conducteur entre les deux motifs de délimitation.

Dans une variante de réalisation, le diélectrique de grille est déposé sur les motifs de délimitation avant le dépôt du matériau électriquement conducteur.

Dans un mode de réalisation particulier, le substrat est recouvert par un motif en matériau semi-conducteur comportant une première couche en premier matériau semi-conducteur recouvrant une deuxième couche en deuxième matériau semi-conducteur. Le procédé comporte :
- graver la première couche en premier matériau semi-conducteur en utilisant le motif de grille comme masque de gravure,
- graver la deuxième couche en deuxième matériau semi-conducteur de manière à former une cavité et suspendre la première couche en premier matériau semi-conducteur,
- déposer un matériau de remplissage de manière à remplir la cavité,
- graver le matériau de remplissage en utilisant le motif de grille comme masque de gravure pour former le motif de partage dans la cavité.

De manière encore plus particulière, le procédé comporte en plus une étape d'épitaxie sélective de manière à former les zones de source et de drain après formation du motif de partage.

Dans une variante de réalisation, le substrat est recouvert par un motif en matériau semi-conducteur comportant successivement une première couche en premier matériau semi-conducteur, une deuxième couche en deuxième matériau semi-conducteur et une troisième couche en troisième matériau semi-conducteur. Les gravures de la deuxième couche et du matériau de remplissage sont configurées pour sauvegarder au moins une partie de la troisième couche de manière à permettre la formation des zones de source et de drain depuis la troisième couche lors de l'étape d'épitaxie sélective.

Plus particulièrement, le motif de partage est réalisé dans un matériau électriquement isolant et le procédé comporte, après élimination du substrat, le dépôt d'un matériau métallique et son recuit pour former un alliage entre le matériau métallique et un matériau semi-conducteur formant les zones de source et/ou de drain.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 11 représentent, de manière schématique, en vue de coupe des étapes successives d'un procédé de réalisation d'un transistor à effet de champ.
- la figure 12 représente, de manière schématique, en vue de coupe une variante de réalisation du transistor à effet de champ illustré à la figure 11,
- la figure 13 représente, de manière schématique, en vue de coupe une variante de réalisation du transistor à effet de champ illustré à la figure 11,
- les figures 14 à 18 représentent, de manière schématique, en vue de coupe des étapes successives d'un deuxième procédé de réalisation d'un transistor à effet de champ,
- les figures 19 à 27 représentent, de manière schématique, en vue de coupe des étapes successives d'un troisième procédé de réalisation d'un transistor à effet de champ.

Les figures A représentent une coupe selon un axe longitudinal de l'électrode de grille. Les figures B représentent une coupe selon un axe transversal de l'électrode de grille.

### Description de modes de réalisation préférentiels de l'invention

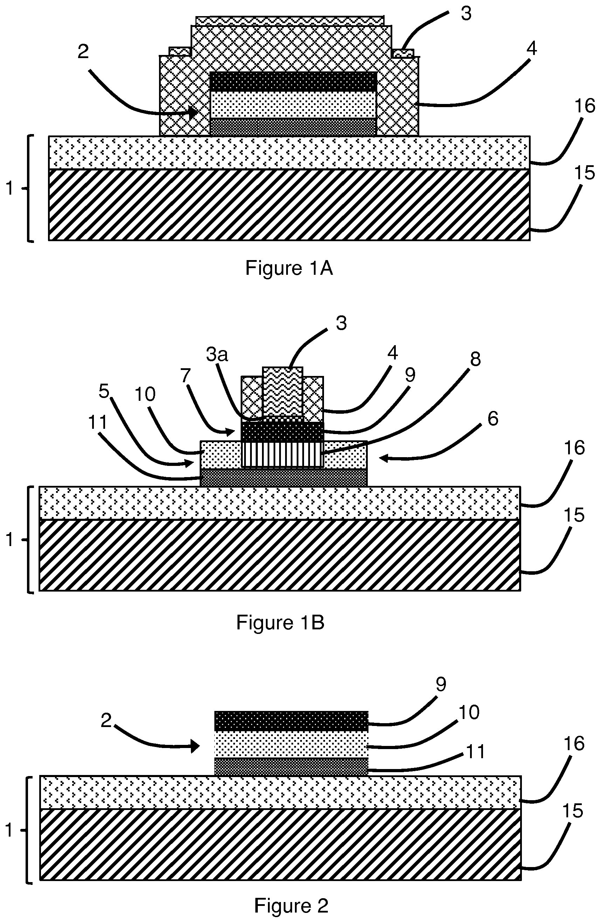

Comme illustré à la figure 1, le procédé de réalisation du dispositif à effet de champ comporte en premier lieu la fourniture d'un substrat 1 dont une face est recouverte par un motif en matériau semi-conducteur 2. Le motif en matériau semi-conducteur 2 est partiellement recouvert par un motif de grille 3. Le motif en matériau semi-conducteur 2 peut également être recouvert par un espaceur latéral 4. Dans le mode de réalisation illustré, le motif en matériau semi-conducteur 2 est en saillie du substrat 1. La figure 1A représente une coupe selon un axe longitudinal du motif de grille. La figure 1B représente une coupe selon un axe transversal du motif de grille.

Le motif de grille 3 définit, à l'intérieur du motif en matériau semi-conducteur 2, une zone de source 5, une zone de drain 6 et un canal de conduction qui relie les zones de source 5 et de drain 6. Le canal de conduction est disposé sous le motif de grille 3.

Le motif en matériau semi-conducteur 2 peut comporter une zone en saillie également appelée zone de conduction 7 qui se trouve sous le motif de grille 3 et entre les futures zones de source 5 et de drain 6. La zone de conduction 7 est en matériau semi-conducteur. Il est également envisageable d'avoir un film continu qui forme le canal de conduction et les zones de source et de drain 5 et 6. Dans cette configuration, la zone de conduction 7 n'est pas obligatoirement en saillie par rapport aux zones de source et de drain. Le canal de conduction correspond sensiblement ou exactement au futur canal de conduction.

Le film semi-conducteur de la figure 1B peut déborder de chaque côté de manière à s'étendre au delà du motif de grille 3.

Le motif en matériau semi-conducteur 2 recouvre ou enrobe un motif de partage 8 qui est disposé sous l'électrode de grille 3 et plus précisément sous la zone de conduction 7 de sorte que les zones de source 5 et de drain 6 sont séparées par le motif de partage 8 sur au moins une partie de leur épaisseur. Le motif de partage 8 comporte au moins trois faces consécutives recouvertes par le motif en matériau semi-conducteur 2.

Dans un mode de réalisation particulier, le motif en matériau semi-conducteur 2 est formé par un empilement d'au moins une première couche 9 en premier matériau semi-conducteur recouvrant une deuxième couche 10 en deuxième matériau semi-conducteur. Les deux matériaux semiconducteurs 9 et 10 sont différents. De manière avantageuse, les première et deuxième couches sont monocristallines et préférentiellement en accord de maille. La première couche 9 est par exemple en silicium et la deuxième couche 10 est en alliage de silicium-germanium, préférentiellement un alliage contenant 30% de germanium, de préférence 30% atomique.

Dans un mode de réalisation encore plus avantageux illustré aux figures 1A, 1B et 2, la deuxième couche 10 en deuxième matériau semi-conducteur recouvre une troisième couche 11 en troisième matériau semi-conducteur. Le deuxième matériau semi-conducteur est différent du troisième matériau semi-conducteur. Le premier matériau semi-conducteur peut être identique au troisième matériau semi-conducteur. Avantageusement, les trois couches 9, 10 et 11 sont monocristallines et préférentiellement en accord de maille.

Les première et troisième couches 9 et 11 sont par exemple en silicium et la deuxième couche 10 est en alliage de silicium-germanium, préférentiellement un alliage contenant 30% de germanium, de préférence 30% atomique.

Cette structure avantageuse peut être réalisée simplement au moyen du procédé qui va suivre.

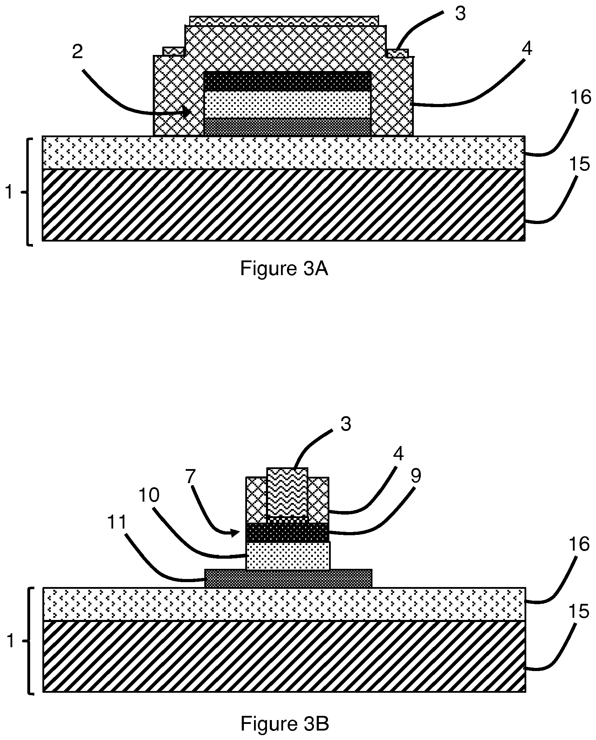

De manière avantageuse illustrée aux figures 3A et 3B, le motif de grille 3 et l'espaceur latéral 4 sont formés sur le motif 2 et sont utilisés pour servir de masque de gravure à la première couche 9 et à la deuxième couche 10. La zone gravée dans la première couche 9 forme la zone de conduction 7 qui est représentative du canal de conduction. La gravure est avantageusement anisotrope afin de définir une zone de conduction 7 qui présente les mêmes dimensions latérales ou sensiblement les mêmes dimensions latérales que l'électrode de grille 3 et l'espaceur latéral 4. L'espaceur latéral 4 peut être formé par une ou plusieurs couches. Il est particulièrement avantageux d'avoir un motif de grille 3 qui déborde sur les deux bords opposés du motif 2.

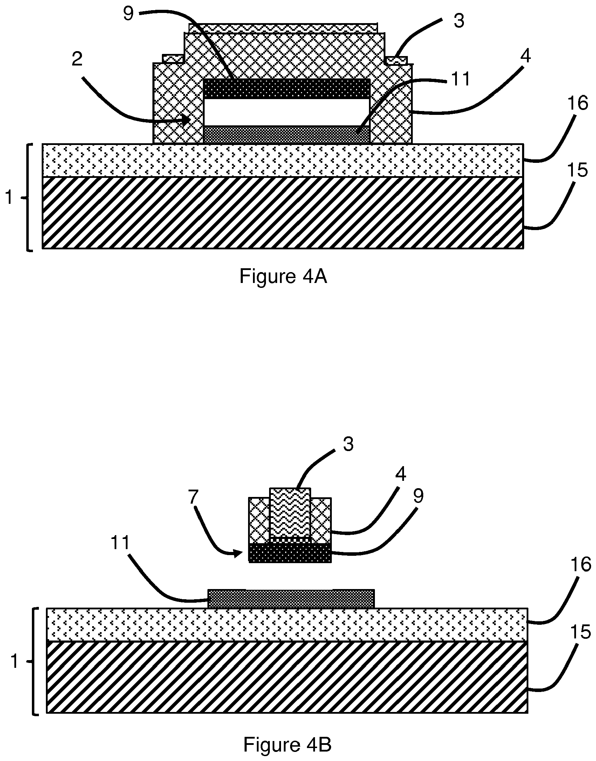

Comme illustré aux figures 4A et 4B, la seconde couche 10 est ensuite éliminée, par toute technique adaptée. La gravure peut être réalisée par voie humide ou par voie sèche. La première couche 9 est alors suspendue au-dessus du substrat 1. La première couche 9 est maintenue au moyen du motif de grille 3 et/ou de l'espaceur latéral 4. La gravure de la seconde couche 10 est avantageusement une gravure isotrope. La gravure de la seconde couche 10 forme une cavité sous la couche 9.

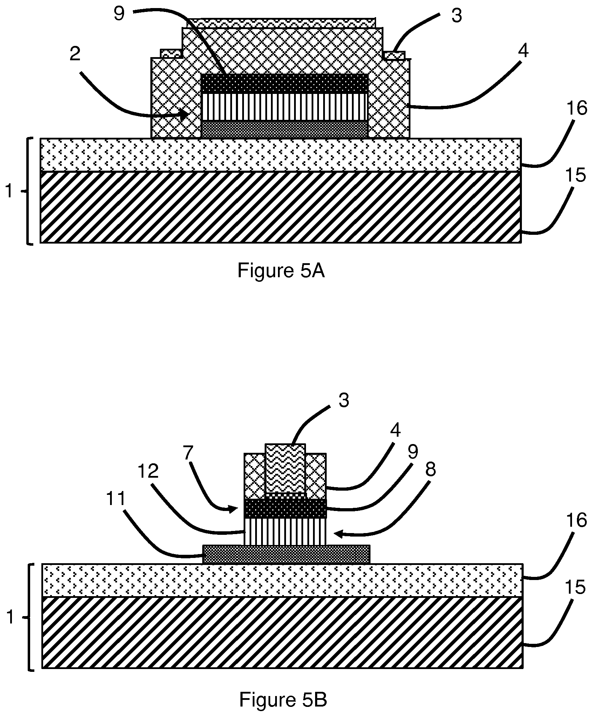

Comme illustré aux figures 5A et 5B, un matériau de remplissage 12 est déposé et gravé de manière à remplir la cavité disposée sous la première couche 9 dans le prolongement du motif de grille 3 et éventuellement de l'espaceur latéral 4. De cette manière, le motif de conduction 7 et le matériau de remplissage 12 formant le motif de partage 8 présentent des parois latérales alignées qui forment les parois du motif 2.

De manière avantageuse, le matériau de remplissage 12 est déposé de manière conforme pour remplir complètement la cavité. Le motif de grille 3 et l'espaceur latéral 4 sont de nouveau utilisés pour réaliser un masque de gravure qui vient localiser le matériau de remplissage 12 uniquement sous la première couche 9. Le motif en matériau de remplissage 12 vient former le motif de partage 8. Le matériau de remplissage 12 est par exemple un oxyde de silicium et plus particulièrement un oxyde déposé à haute température (HTO). L'épaisseur de matériau de remplissage 12 est avantageusement supérieure à la moitié de l'épaisseur de la deuxième couche 10 ou de la hauteur de la cavité qui existe sous la première couche 9.

En variante, un autre matériau de remplissage peut être déposé comme un nitrure de silicium ou un empilement de plusieurs couches. Il est également envisageable de prévoir une oxydation de la première couche 9 pour remplir la cavité. Dans ce dernier cas de figure, l'épaisseur et la largeur de la première couche 9 sont choisies en conséquence et une désoxydation des flancs de la première couche 9 est réalisée pour autoriser une future étape d'épitaxie. Si une couche 11 est utilisée, cette dernière peut être oxydée.

Il est également possible de prévoir le remplissage de la cavité par plusieurs couches dont au moins une des couches est contrainte en tension ou en compression de manière à appliquer des contraintes sur le canal de conduction. De manière avantageuse, pour un transistor de type Nmos, l'empilement de couches comporte au moins une couche en nitrure de silicium contrainte en tension. Pour un transistor de type Pmos, l'empilement de couches comporte au moins une couche en nitrure de silicium contrainte en compression.

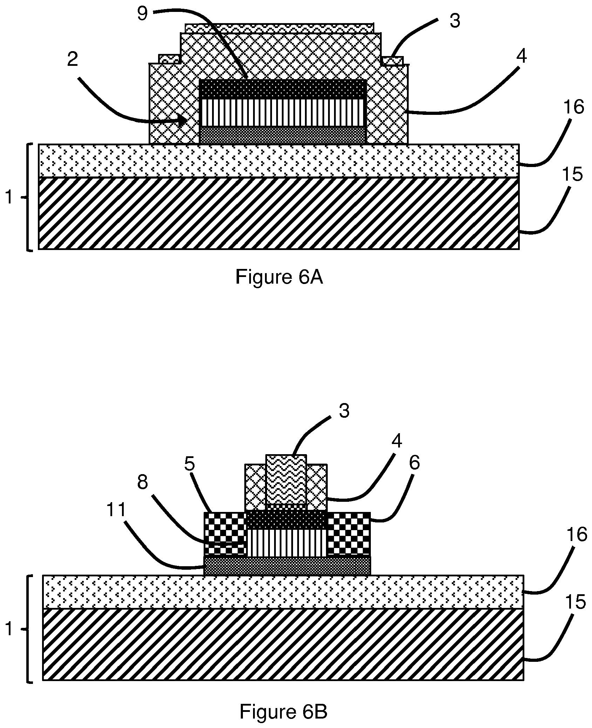

Comme illustré aux figures 6A et 6B, une épitaxie sélective est ensuite réalisée pour faire croitre un matériau semi-conducteur à partir de la première couche 9 et former les zones de source et de drain. Dans ce cas de figure, il est particulièrement avantageux d'utiliser la troisième couche 11 qui permet d'augmenter la surface disponible pour le démarrage de l'épitaxie. Le matériau semi-conducteur déposé va former les zones de source 5 et de drain 6.

Le document US2013/0299897 décrit la croissance d'une couche de silicium ou de silicium-germanium depuis le substrat de support et la couche de semi-conducteur sur isolant. Or, le substrat de support et la couche de semi-conducteur sur isolant ne sont pas alignés lors de la formation du substrat de type semi-conducteur sur isolant. Ce léger désalignement empêche une reprise d'épitaxie de très bonne qualité et des défauts cristallins peuvent se former dans les zones de source et de drain. En revanche, dans le procédé présenté plus haut, l'épitaxie est réalisée à partir de la couche 9 ou à partir des couches 9 et 11 qui étaient initialement en accord de maille. Cette précaution permet d'avoir une reprise d'épitaxie de meilleure qualité.

Pour former des transistors différents, il est également possible de prévoir, sur le substrat, des empilements différents, par exemple avec des épaisseurs différentes de la couche 10 ce qui n'est pas possible avec un substrat de type semi-conducteur sur isolant.

Le motif en matériau semi-conducteur 2 peut être dopé par implantation de dopants électriques dans les zones de source 5 et de drain 6. Si une épitaxie est réalisée, il est également envisageable de réaliser un dopage in-situ lors du dépôt du matériau semi-conducteur par épitaxie.

Lors de l'étape d'épitaxie sélective, il est possible de distinguer les transistors Nmos et les transistor Pmos en réalisant deux étapes différentes qui sont destinées à déposer deux matériaux différents. Pour les transistors Pmos, il est avantageux de déposer un alliage de silicium-germanium. Pour les transistors Nmos, il est avantageux de déposer du silicium.

L'utilisation d'un substrat de type semi-conducteur sur isolant tel que décrit dans le document US 2013/0299897 ne permet pas non plus de former des zones contraintes en tension et des zones contraintes en compression au moyen de la couche d'isolant enterré.

Dans un mode de réalisation avantageux non représenté, un deuxième espaceur latéral est formé en plus de l'espaceur latéral 4. Ce deuxième espaceur latéral vient recouvrir une partie des zones de source et de drain. Une implantation de dopants électriques est réalisée avec une dose plus importante de manière à former des zones de source/drain faiblement résistives. Le deuxième espaceur latéral permet de décaler les dopants par rapport au canal de conduction.

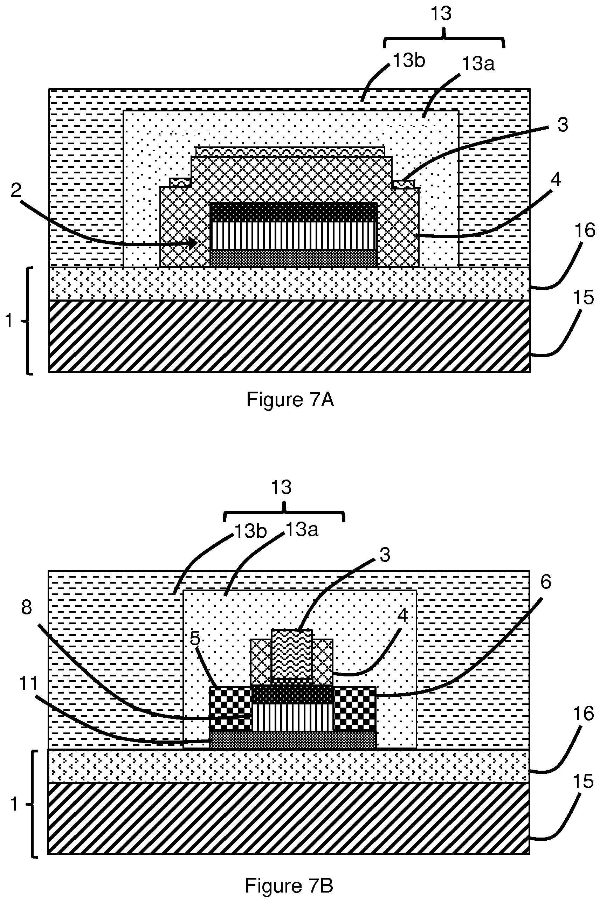

Comme illustré aux figures 7A et 7B, l'ensemble est ensuite recouvert par au moins une couche de couverture 13 électriquement isolante. Dans le mode de réalisation illustré, la couche de couverture comporte une première sous-couche de couverture 13a qui est en contact avec les zones de source/drain et le motif de grille 3. Une deuxième sous-couche de couverture 13b est déposée de manière à recouvrir la première sous-couche 13a et former une surface externe plus plane. De manière avantageuse, une étape d'aplanissement est réalisée pour former une surface supérieure plane. A titre d'exemple, l'aplanissement est réalisé par une étape de polissage mécano-chimique. La couche 13a peut être structurée avant le dépôt de la couche 13b ou être laissée inchangée.

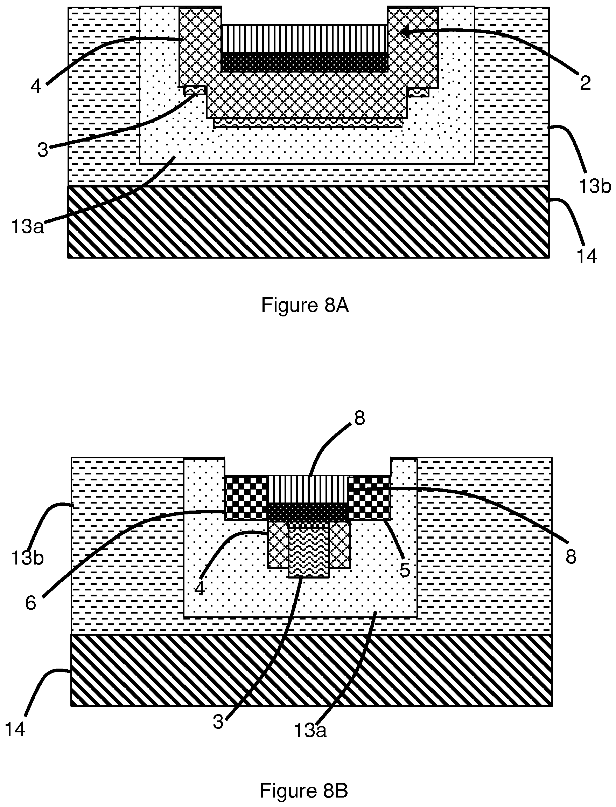

Comme illustré aux figures 8A et 8B, la face supérieure de la couche de couverture 13 est ensuite fixée à un second substrat 14 et le premier substrat 1 est éliminé de manière à accéder au motif de partage 8, aux zones de source 5 et de drain 6 et au motif de grille 3. De manière avantageuse, la face supérieure de la couche de couverture 13 est collée au second substrat 14. A titre d'exemple, le second substrat 14 est un substrat massif de silicium qui comporte avantageusement une couche d'oxyde de silicium en surface pour faciliter le collage de la couche de couverture 13. Dans le mode de réalisation illustré aux figures 8A et 8B, la couche 11 est complètement éliminée. En variante, il est possible de laisser la couche 11 sur les zones de source et de drain mais il est nécessaire de former un masque de gravure spécifique pour éviter un court-circuit entre les zones de source et de drain. La couche 11 peut être électriquement conductrice pour former par la suite les contacts de source et de drain.

Pour faciliter l'élimination du premier substrat 1, il est avantageux d'utiliser un substrat de type semi-conducteur sur isolant dans lequel la deuxième couche 10 ou la troisième couche 11 est formée par la couche active du substrat 1. Cette couche active est séparée du substrat de support 15 par la couche électriquement isolante 16. Le substrat de support 15 est éliminé pour accéder à la couche électriquement isolante 16. Ensuite, la couche électriquement isolante 16 est éliminée ce qui libère l'accès aux zones de source/drain, au motif de partage 8 et au motif de grille 3. Le substrat de support 15 en silicium peut être éliminé par une abrasion mécanique suivie d'une abrasion chimique avec une solution de TMAH. La couche électriquement isolante 16 peut être ensuite éliminée par une solution de type acide fluorhydrique. A titre d'exemple, une solution contenant entre 0,1% et 2% d'acide fluorhydrique permet d'avoir une sélectivité importante vis-à-vis des matériaux communément utilisés dans la formation d'un dispositif à effet de champ, par exemple le nitrure de silicium, un diélectrique de grille à plus forte permittivité.

En variante, il est également possible de prévoir un substrat 1 qui comporte une partie support 15 séparée de la deuxième ou de la troisième couche par un matériau différent 16 de manière à faciliter la gravure du support 15 avec la détection de la couche en matériau différent 16. La couche en matériau différent 16 est ensuite gravée sélectivement pour libérer l'accès aux zones recherchées. Le matériau différent 16 est par exemple une couche en alliage de silicium-germanium.

Malgré le changement de face active lié au remplacement du substrat 1 par le substrat 14, il est possible de réaliser facilement des contacts de source et/ou de drain avec les zones de source et/ou de drain.

Après élimination du substrat 1, l'accès est aisé aux zones de source 5 et de drain 6, au canal de conduction et à l'électrode de grille 3.

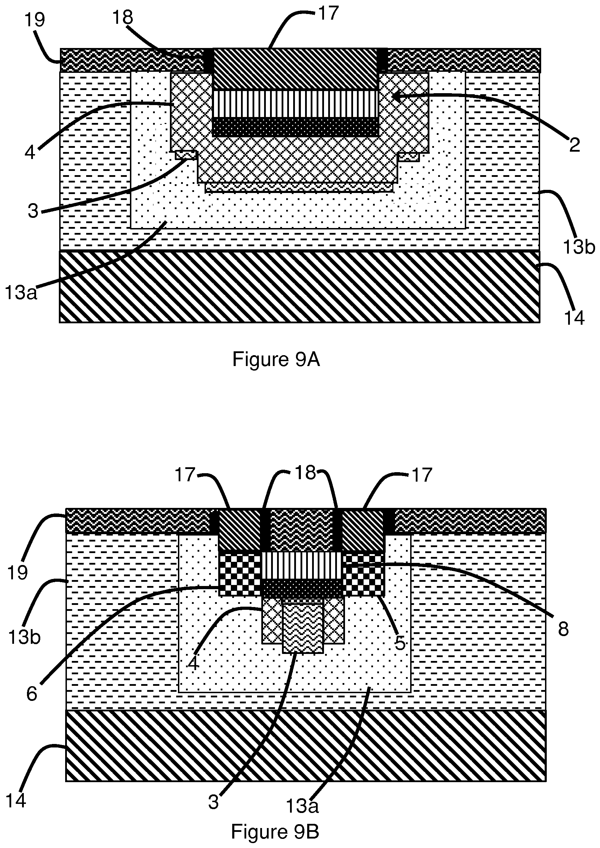

Comme illustré aux figures 9A et 9B, deux motifs de délimitation 17 sont formés sur les zones de source 5 et de drain 6 afin de les recouvrir et de protéger les zones de source et de drain. Les motifs de délimitation 17 libèrent une zone au-dessus du motif de partage 8. De manière avantageuse, les motifs de délimitation 17 recouvrent complètement les zones de source 5 et de drain 6. Il est particulièrement avantageux d'avoir des motifs 17 qui ont les mêmes dimensions latérales que les zones de source et de drain.

Les motifs de délimitation 17 peuvent être formés par toute technique adaptée, par exemple par dépôt d'une couche d'un premier matériau suivi d'une étape de photolithographie et de gravure de ce premier matériau. Comme les motifs de délimitation sont formés en contact avec les zones de source et de drain, les signaux d'alignement sont peu perturbés ce qui facilite le positionnement des motifs 17 par rapport aux zones de source et de drain. De manière avantageuse, les motifs de délimitation 17 sont formés au moyen d'un dépôt sélectif à partir des zones de source 5 et de drain 6. De cette manière, les motifs de délimitation 17 sont auto-alignés avec les zones de source 5 et de drain 6. A titre d'exemple, les motifs de délimitation 17 sont formés par épitaxie sélective de silicium ou d'alliage de silicium-germanium. En variante, il est également envisageable de réaliser le dépôt non sélectif d'un matériau qui aura une structure monocristalline sur les zones de source et de drain et une structure polycristalline ou amorphe hors des zones de source et de drain. Une gravure préférentielle des zones amorphes ou polycristallines par rapport à la zone monocristalline permet de localiser le motif de délimitation 17 au-dessus des zones de source et de drain. De manière avantageuse, le matériau formant les motifs de délimitation 17 est différent du matériau formant les zones de source 5 et de drain 6.

Il est avantageux de doper les zones de source et de drain avant de former les motifs 17 car les zones de source et de drain sont accessibles.

De manière avantageuse illustrée aux figures 9A et 9B, un espaceur latéral 18 est formé sur les parois latérales des motifs de délimitation 17. Il est particulièrement avantageux de réaliser l'espaceur 18 latéral dans un matériau électriquement isolant. L'espaceur latéral 18 vient recouvrir une partie du motif de partage 8.

Une deuxième couche de couverture 19 ou une partie de la deuxième couche de couverture 19 est déposée de manière à recouvrir le motif de partage 8 et remplir les espaces entre les motifs de délimitation 17.

De manière avantageuse illustrée aux figures 9A et 9B, le dépôt de la deuxième couche de couverture 19 est suivi d'une étape de polissage mécano-chimique pour former une surface plane définie par les motifs de délimitation 17 et la deuxième couche de couverture 19.

Cette configuration est particulièrement avantageuse car elle permet aisément de localiser les zones de source et de drain au moyen des motifs de délimitation 17. Le reste du dispositif est protégé par la couche de couverture 19.

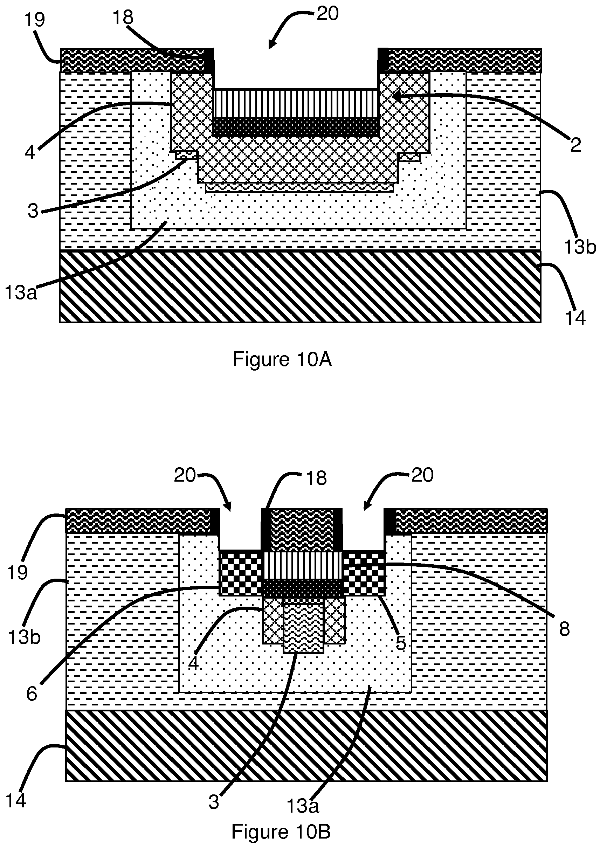

Comme illustré aux figures 10A et 10B, les motifs de délimitation 17 sont ensuite éliminés pour accéder aux zones de source 5 et de drain 6. L'élimination des motifs de délimitation 17 forme des cavités 20. A cette étape, il est également possible de doper les zones de source et de drain par implantation avec une énergie faible.

De manière optionnelle, un nouvel espaceur latéral (non représenté) peut être formé sur les parois latérales des cavités 20. En alternative, il est possible de ne pas former l'espaceur latéral 18 sur les bords des motifs 17 avant le dépôt de la couche 19 mais de former l'espaceur latéral 18 sur le bord de la couche 19 après l'élimination des motifs 17.

Le nouvel espaceur latéral peut être utilisé pour écarter les bords des contacts de source et de drain et ainsi réduire les capacités parasites. Comme précédemment, le nouvel espaceur latéral peut être formé par une étape de dépôt avantageusement de manière conforme suivie d'une étape de gravure anisotrope selon une direction perpendiculaire à la face de la couche 19.

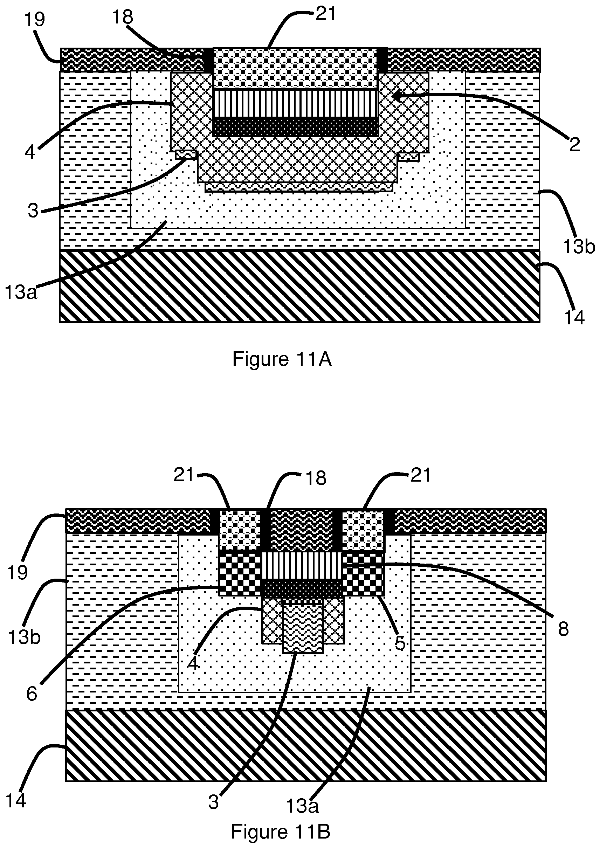

Comme illustré aux figures 11A et 11B, un matériau électriquement conducteur 21 est déposé de manière à remplir au moins partiellement les cavités 20 formées dans la deuxième couche de couverture 19 au-dessus des zones de source 5 et de drain 6. Le matériau conducteur 21 est avantageusement un métal.

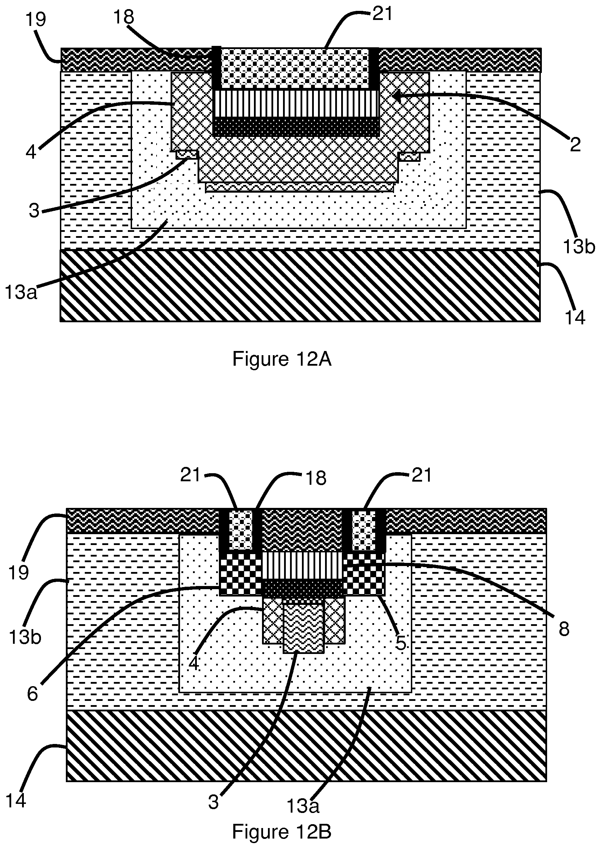

Dans la variante de réalisation illustrée aux figures 12A et 12B, l'espaceur latéral 18, n'a pas été formé sur les parois des motifs 17 avant de déposer la couche 19. L'espaceur latéral a été formé sur les parois de la couche 19 après élimination du motif 17. On constate que les dimensions des contacts sont légèrement différentes.

Dans ces modes de réalisation, il est avantageux de réaliser le dépôt d'un métal suivi par un recuit configuré pour faire réagir le métal avec le matériau formant les zones de source 5 et de drain 6 et former un alliage 22 par exemple de type siliciure et/ou germaniure.

De manière avantageuse, le dépôt du métal est suivi par le dépôt d'un matériau barrière (non représenté) qui est configuré pour bloquer la diffusion de certains éléments et notamment l'oxygène. Le matériau barrière est électriquement conducteur.

De manière préférentielle, le dépôt du matériau électriquement conducteur 22 est suivi par le dépôt du matériau barrière, préférentiellement un métal. Le dépôt du matériau barrière peut également être suivi par le dépôt d'un autre matériau électriquement conducteur, par exemple du tungstène, afin de réduire les résistances de contact.

Pour localiser le matériau électriquement conducteur 21 et/ou le métal au-dessus des zones de source 5 et de drain 6, il est avantageux de réaliser une étape de polissage mécano-chimique qui s'arrête préférentiellement à la surface de la couche 19. De manière préférentielle, le matériau électriquement conducteur 21 et/ou le matériau barrière et/ou l'autre matériau électriquement conducteur sont déposés au moyen d'une technique de dépôt directif, par exemple par pulvérisation.

Ainsi, le matériau électriquement conducteur 21 et l'autre matériau électriquement conducteur sont localisés aisément dans le fond des cavités 20 formées par le retrait des motifs 17.

Par soucis de clarté, seul le matériau électriquement conducteur 21 est représenté dans les figures 11A, 11B, 12A et 12B.

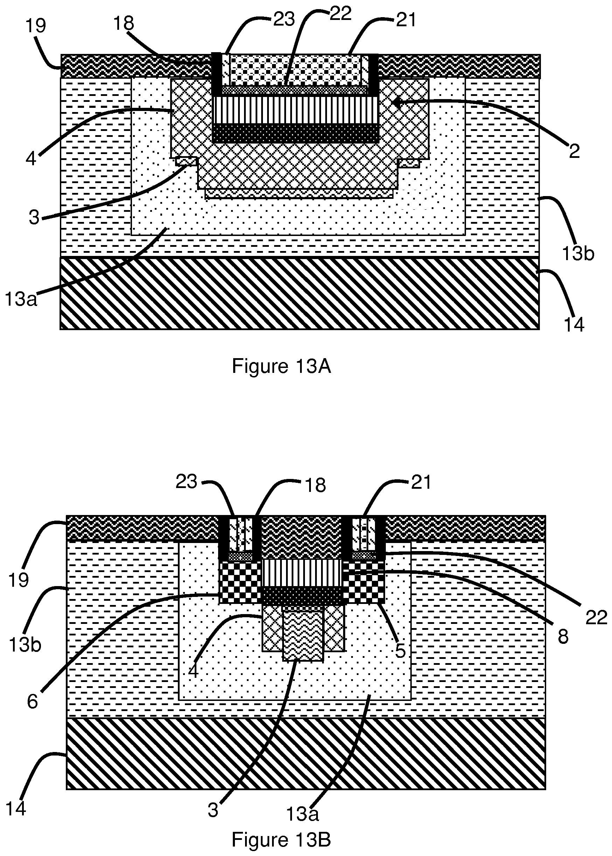

Dans une variante de réalisation illustrée aux figures 13A et 13B, une couche électriquement isolante est formée après la formation de l'alliage 22. La couche électriquement isolante est déposée dans les cavités 20 formées par le retrait des motifs 17 de manière à recouvrir les parois latérales et le fond de la cavité 20. Préférentiellement, la couche électriquement isolante est déposée de manière conforme, c'est-à-dire que l'épaisseur sur les parois verticales est identique à l'épaisseur sur les parois horizontales.

Une étape de gravure anisotrope est réalisée de manière à former des espaceurs latéraux additionnels 23 à partir de la couche électriquement isolante. Ces espaceurs 23 permettent d'augmenter l'espace entre les contacts et donc de diminuer les capacités parasites entre les contacts de source et de drain. Le mode de réalisation des figures 13A et 13B avec un espaceur additionnel 23 peut être réalisé soit en relation avec le mode de réalisation illustré aux figures 11A et 11B soit en relation avec le mode de réalisation des figures 12A et 12B.

Par la suite, le contact d'électrode de grille (non représenté) peut être réalisé par tout moyen adapté, par exemple par la formation d'un masque de gravure puis la gravure de la deuxième couche de couverture 19 pour accéder au motif de grille 3.

Un trou est formé de manière à atteindre le motif de grille 3, le trou est au moins formé dans la couche 19 et éventuellement dans d'autres couches.

Un matériau électriquement conducteur, par exemple un métal, est ensuite déposé de manière à venir en contact avec le motif de grille 3.

Si le motif de grille 3 est une « fausse grille », ce dernier est retiré et remplacé par les matériaux adaptés à la formation d'une électrode de grille. Le motif est retiré pour former une nouvelle cavité. Le volume de la nouvelle cavité délimitée par le motif en matériau semi-conducteur 2 et la couche 13 est ensuite rempli par un diélectrique de grille 3a et par un matériau électriquement conducteur qui va former le conducteur de grille.

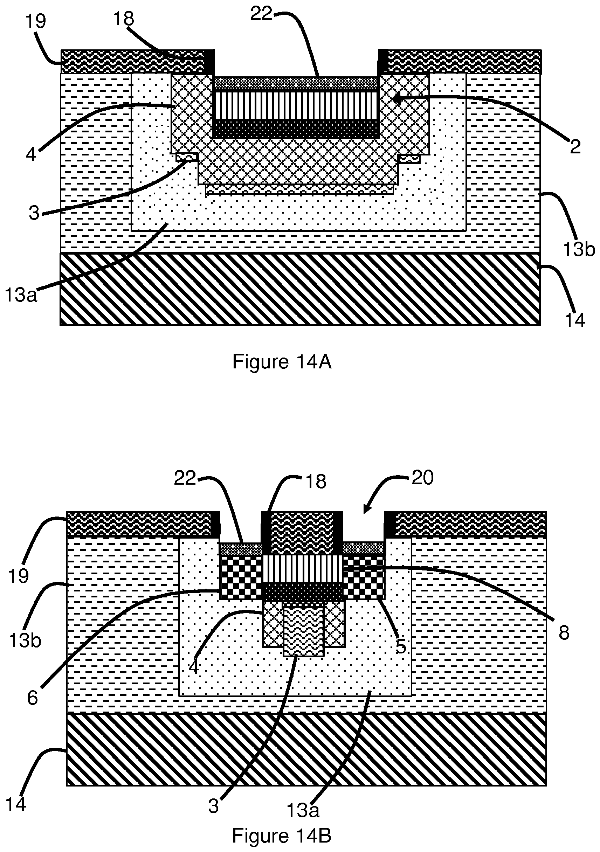

Dans encore un autre mode de réalisation particulier illustré à partir des figures 14A et 14B, il est possible de former en même temps le contact du motif de grille 3 et les contacts de source et de drain.

Le début du procédé est identique à ce qui a été décrit précédemment jusqu'aux figures 10A et 10B.

Dans ce mode de réalisation, il est particulièrement avantageux de déposer un métal qui sera recuit pour former l'alliage 22 sur les zones de source et de drain. Le métal ou l'alliage 22 peut être recouvert par une couche barrière non représentée.

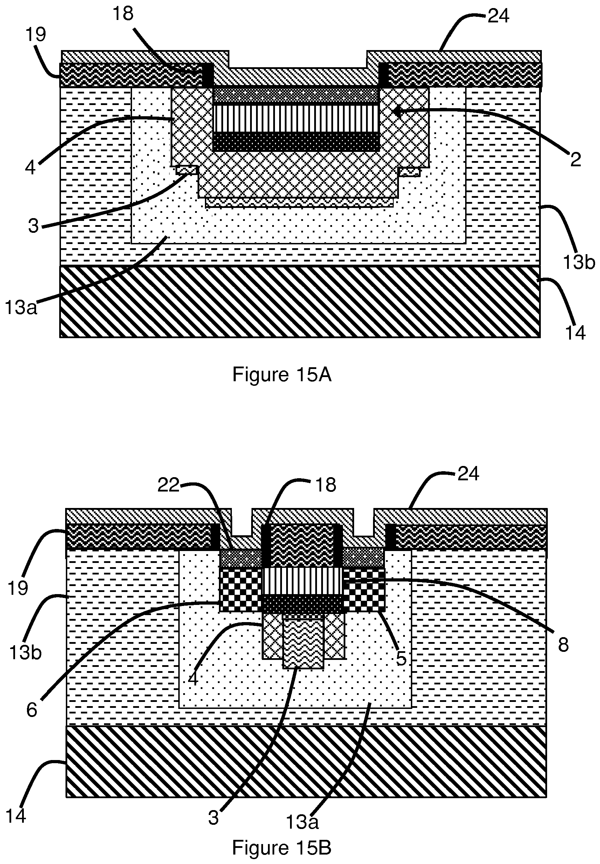

Comme illustré aux figures 15A et 15B, une couche électriquement isolante 24 est déposée dans les cavités 20 pour recouvrir les parois latérales et le fond de la cavité 20. De manière avantageuse, la couche électriquement isolante 24 est déposée de manière conforme.

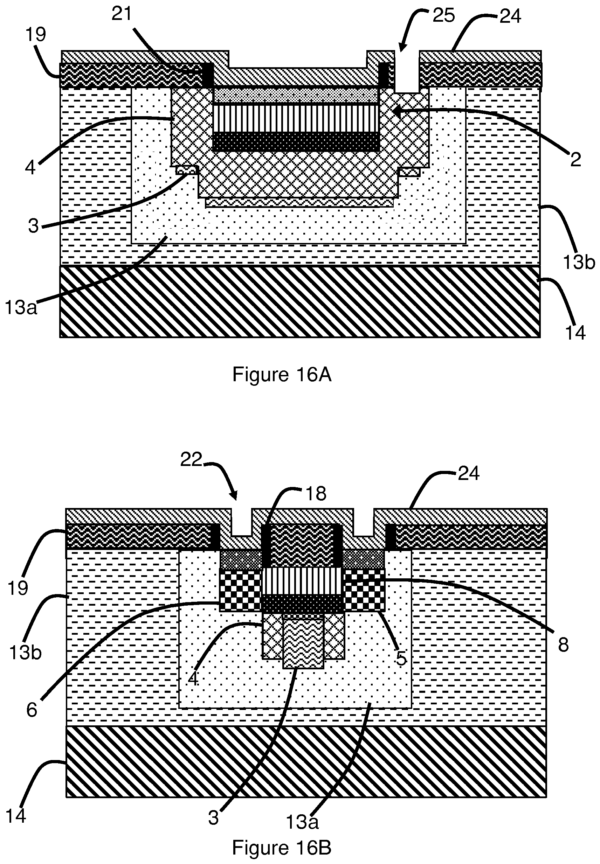

Comme illustré aux figures 16A et 16B, un trou 25 est formé dans la couche électriquement isolante 24 et dans la couche 19 pour accéder au motif de grille 3.

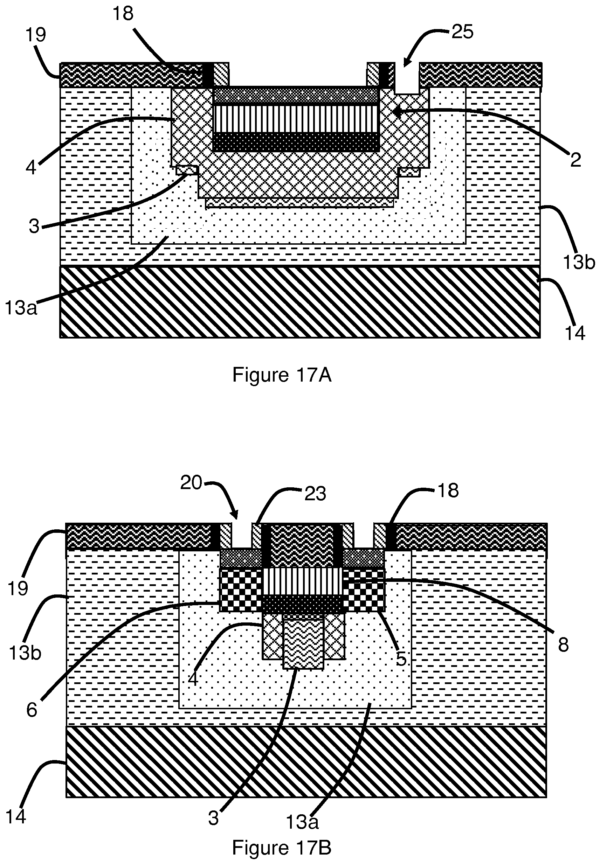

Comme illustré aux figures 17A et 17B, une gravure anisotrope est ensuite réalisée pour former des espaceurs latéraux additionnels 23 à partir de la couche électriquement isolante 24. Ce mode de réalisation est très proche de celui illustré à la figure 13.

En variante, il est possible de réaliser la formation des espaceurs latéraux 23 à partir de la couche 24 avant de former le trou de contact 25.

Il est également possible de réaliser la formation du trou de contact 25 avant de déposer la couche électriquement isolante 24. Cependant, cela implique de former un trou de contact 25 ayant des dimensions importantes de manière à éviter qu'il soit rebouché lors du dépôt de la couche électriquement isolante 24. Un tel trou de contact 25 n'est pas toujours réalisable dans une structure compacte.

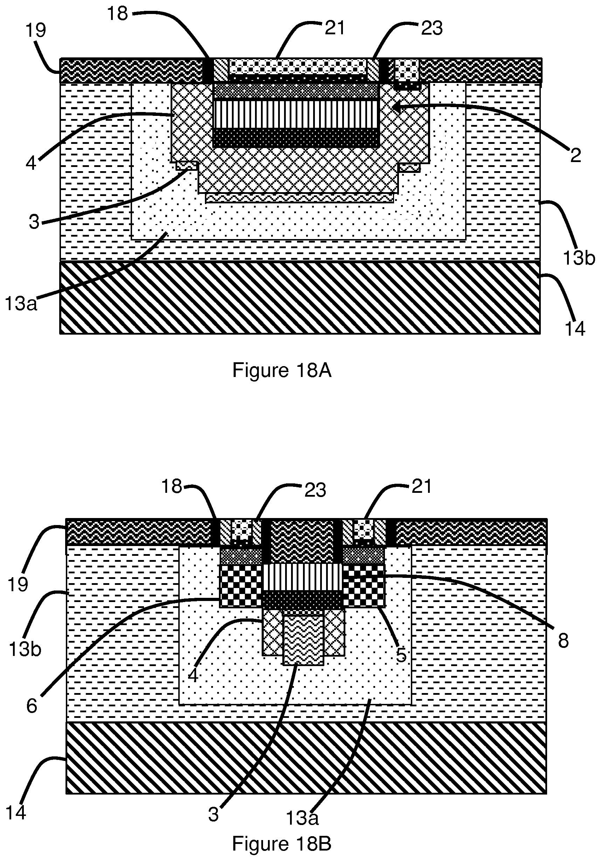

Comme illustré aux figures 18A et 18B, un ou plusieurs matériaux électriquement conducteurs sont ensuite déposés de manière à remplir le trou de contact 25 et les cavités 20. Il est par exemple possible de déposer le matériau électriquement conducteur 21.

Les contacts de source, de drain et le contact d'électrode de grille sont formés en même temps. Là encore, il est avantageux de réaliser la localisation du deuxième matériau électriquement conducteur 21 par une étape de polissage mécano-chimique.

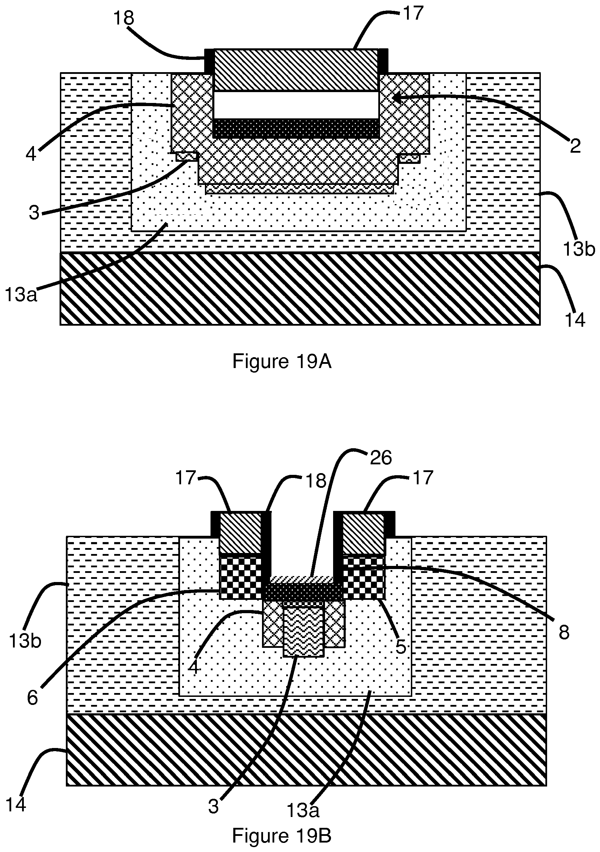

Dans un autre mode de réalisation illustré à partir des figures 19A et 19B, il est également possible d'intégrer une deuxième électrode de grille qui vient contrôler au moins partiellement le canal de conduction.

Le procédé de réalisation reprend ce qui a été expliqué précédemment et illustré jusqu'aux figures 8A et 8B.

Des motifs de délimitation 17 sont formés comme précédemment. Ces motifs de délimitation 17 sont avantageusement recouverts des espaceurs latéraux 18. Cette étape est très proche de ce qui est illustré aux figures 10A et 10B à l'exception de la couche 19 qui n'est pas déposée.

Si le motif de partage 8 n'est pas réalisé dans un matériau électriquement isolant ou si les caractéristiques électriques du motif de partage 8 ne sont pas adaptées, le motif de partage 8 est éliminé.

Si le motif de partage 8 est trop épais, il est possible de le graver partiellement de manière à l'amincir.

Dans le mode de réalisation illustré, le motif de partage 8 est éliminé et un matériau électriquement isolant 26 est déposé pour former un diélectrique de grille. En variante, l'espaceur latéral 18 peut être formé après le dépôt du diélectrique de grille 26.

De manière avantageuse, un espaceur latéral 18 est formé sur les parois latérales des motifs de délimitation 17. Il est particulièrement avantageux de réaliser l'espaceur latéral 18 dans un matériau électriquement isolant et de préférence dans un matériau ayant une constante diélectrique inférieure à celle de l'oxyde de silicium. A titre d'exemple, l'espaceur latéral 18 est en nitrure de bore.

Selon les modes de réalisation, l'espaceur latéral 18 s'appuie sur le motif de partage 8 électriquement isolant ou sur le canal de conduction ou sur un nouveau diélectrique de grille 26. Avantageusement, l'espaceur latéral 18 est formé après amincissement ou retrait du motif de partage 8.

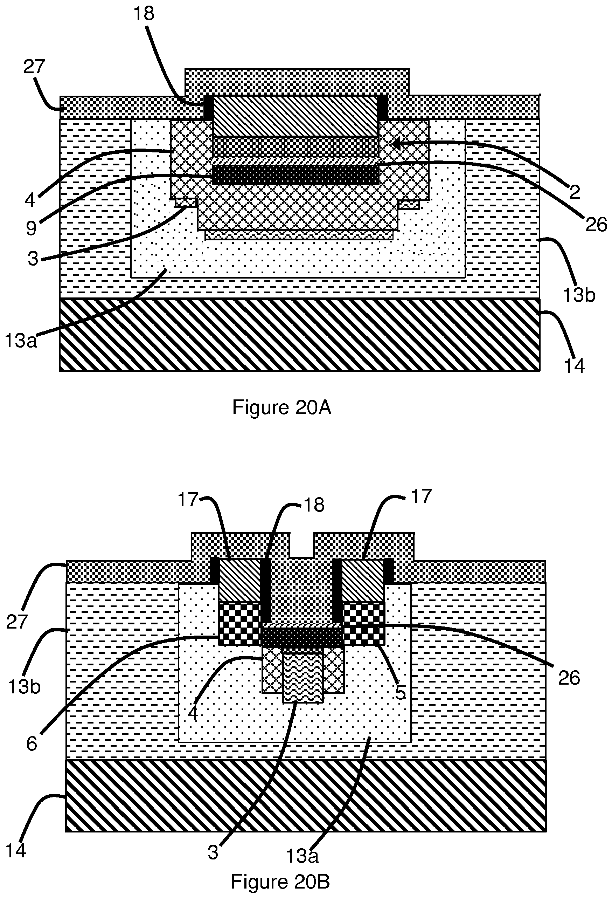

Comme illustré aux figures 20A et 20B, un deuxième matériau électriquement conducteur 27, avantageusement un métal, est ensuite déposé de manière à recouvrir le trou disposé entre les motifs 17 surmontant les zones de source et de drain et au-dessus du canal de conduction et notamment le trou formé par le motif de partage 8 si ce dernier est éliminé.

Si le deuxième matériau électriquement conducteur 27 se dépose également sur les motifs de délimitation 17, ce dernier peut être retiré juste après. De manière avantageuse, si un nouveau diélectrique de grille 26 est formé après élimination du motif de partage 8, il est intéressant de déposer le diélectrique de grille 26 sur les motifs 17 de manière à les recouvrir et à réduire les risques de contamination ou de réaction entre le matériau 27 et le matériau formant les motifs 17.

Si les motifs 17 sont en silicium ou en silicium-germanium et que le matériau 27 est en métal, il est avantageux de conserver le diélectrique de grille 26 pour éviter la formation d'un siliciure qui devient difficile à éliminer par rapport aux autres matériaux présents.

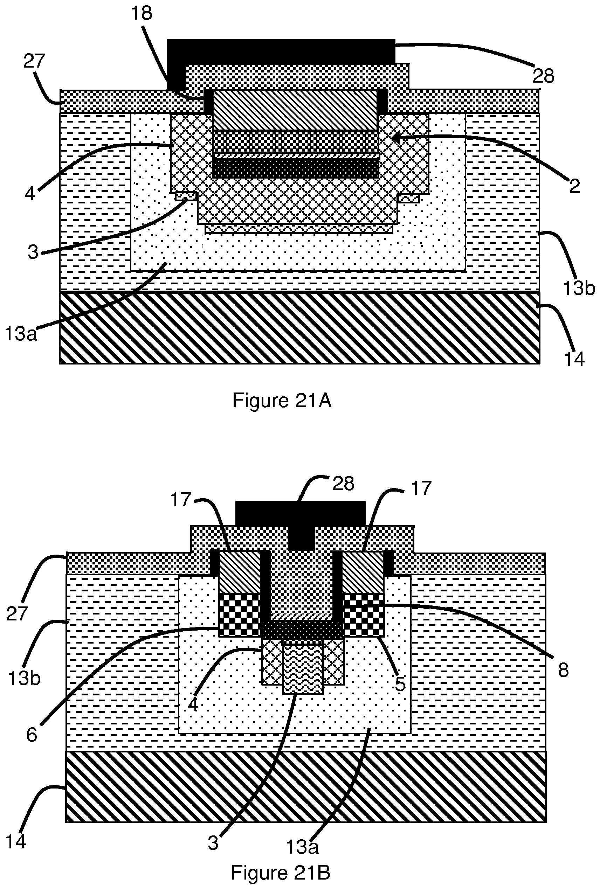

Comme illustré aux figures 21A et 21B, un masque de gravure 28 est formé de manière à localiser le deuxième matériau électriquement conducteur 27 au moins sur une partie des motifs 17 et entre les deux motifs 17 au-dessus du canal de conduction. Cependant, en variante, le masque 28 peut également être configuré pour localiser le matériau 27 uniquement dans la cavité définie par les deux motifs 17, mais cela nécessite des contraintes d'alignements supplémentaires

Le masque de gravure 28 définit la longueur de la deuxième électrode de grille. Le masque de gravure 28 peut également être configuré pour que le deuxième matériau électriquement conducteur 27 s'étende au delà des motifs 17 dans le sens longitudinal des motifs 17.

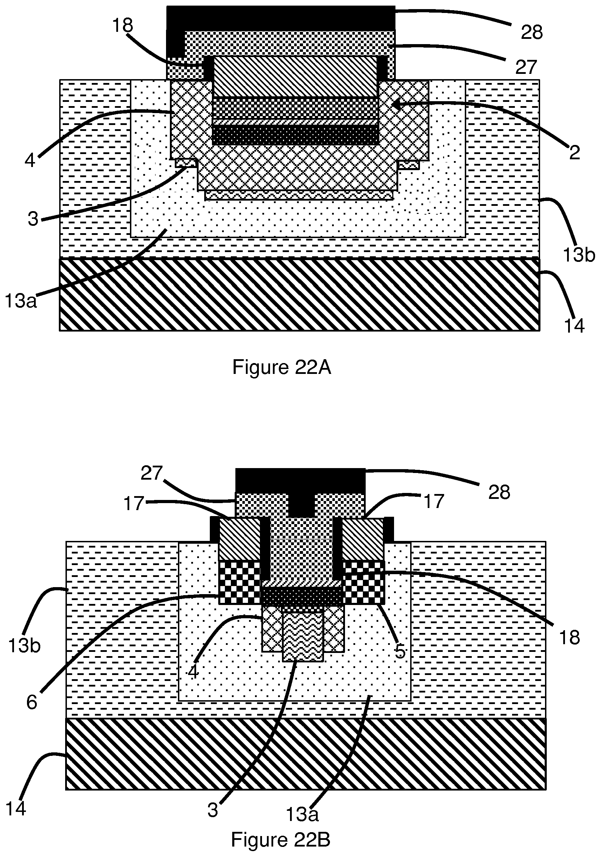

Comme illustré aux figures 22A et 22B, le deuxième matériau électriquement conducteur 27 est gravé dans les zones non protégées par le masque de gravure 28. De cette manière, le deuxième matériau électriquement conducteur 27 vient former la deuxième électrode de grille et il est électriquement dissocié des autres dispositifs présents à la surface du substrat.

A titre d'exemple, l'étape de dépôt du deuxième matériau électriquement conducteur 27 est suivie d'une étape de polissage mécano-chimique et éventuellement d'une gravure ionique pour rabaisser le niveau supérieur du deuxième matériau électriquement conducteur 27 par rapport au niveau supérieur des motifs de délimitation 17. Le deuxième matériau électriquement conducteur 27 vient former le conducteur de grille pour la deuxième électrode de grille.

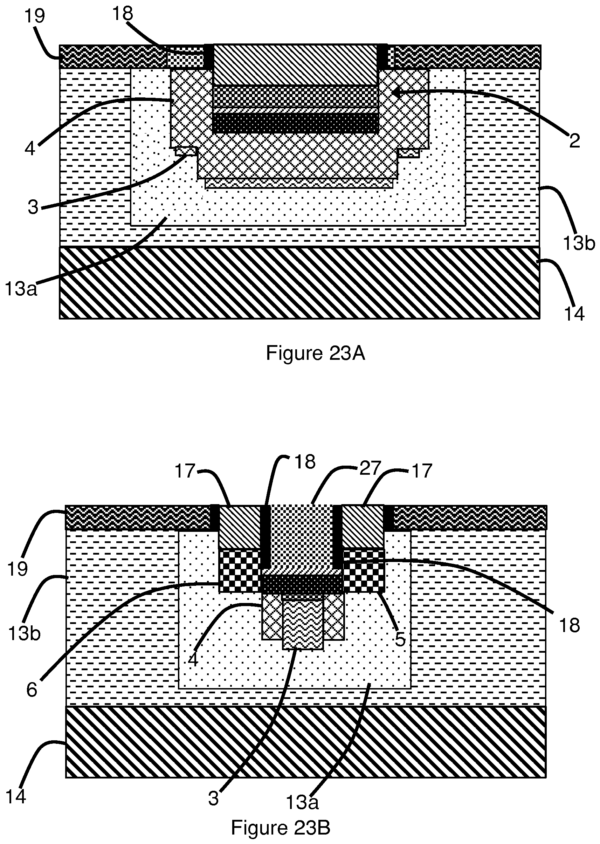

Comme illustré aux figures 23A et 23B, la deuxième couche de couverture 19 ou une partie de la deuxième couche de couverture 19 est déposée de manière à recouvrir le substrat et combler les trous autour des motifs de délimitation 17. Le dépôt de la deuxième couche 19 est par exemple un dépôt sur toute la surface du substrat.

De manière avantageuse illustrée aux figures 23A et 23B, le dépôt de la deuxième couche de couverture 19 est suivi d'une étape de polissage mécano-chimique pour former une surface plane définie par les motifs de délimitation 17, le matériau 27 entre les motifs de délimitation 17 et la deuxième couche de couverture 19.

Dans un mode de réalisation avantageux, la même étape de polissage mécano-chimique est utilisée pour localiser le matériau 27 et la deuxième couche de couverture 19.

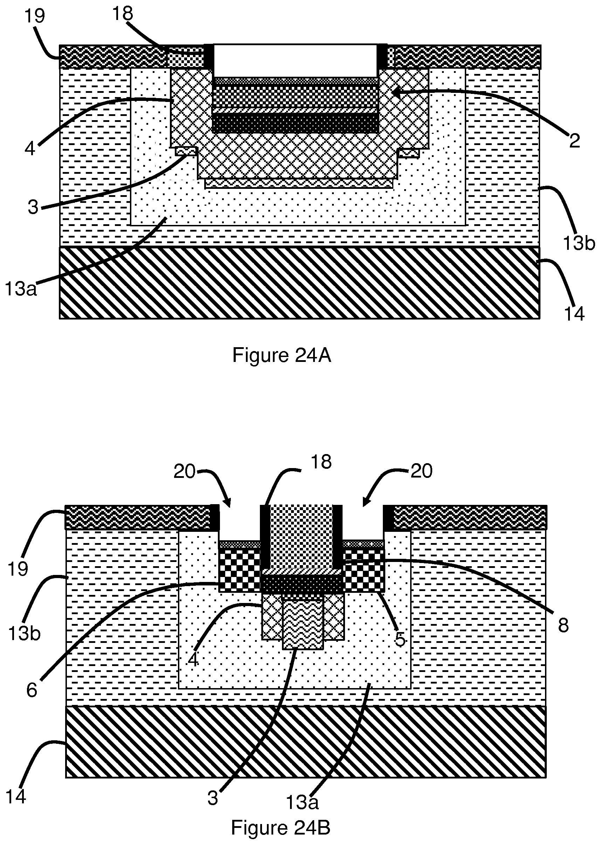

Comme illustré aux figures 24A et 24B, les motifs de délimitation 17 sont ensuite éliminés pour accéder aux zones de source 5 et de drain 6. L'élimination des motifs de délimitation 17 forme les cavités 20.

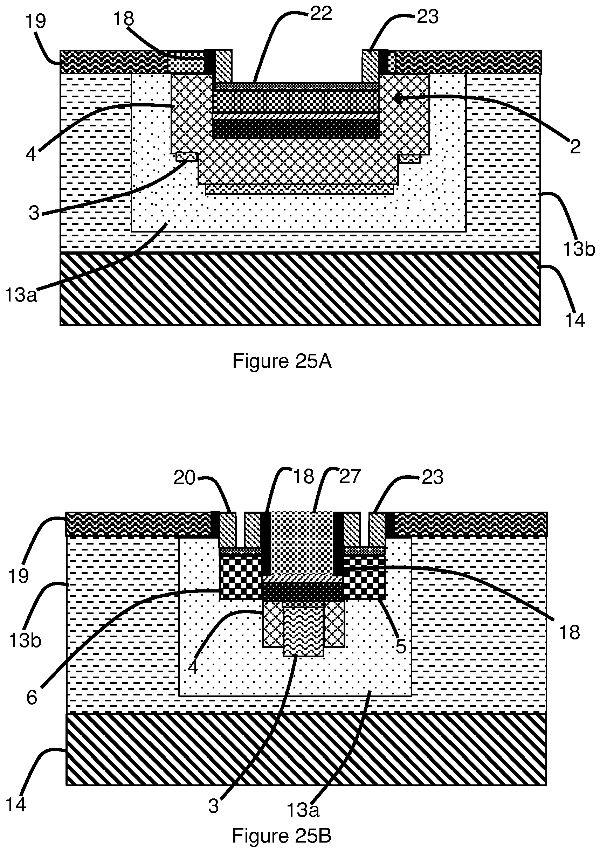

De manière optionnelle illustrée aux figures 25A et 25B, un espaceur latéral additionnel 23 peut être formé sur les parois latérales des cavités 20. En alternative, il est possible de ne pas former l'espaceur latéral 18 sur les bords des motifs 17 avant le dépôt de la couche 19 mais de le former sur le bord de la couche 19 et du matériau 27 après l'élimination des motifs 17.

L'espaceur 23 peut être formé au moyen d'une étape de dépôt suivie d'une étape de gravure anisotrope.

Dans le mode de réalisation illustré, l'espaceur latéral additionnel 23 est formé après la formation de l'alliage 22. Cependant, il est également possible de prévoir la formation de l'espaceur latéral additionnel 23 avant la formation de l'alliage 22. L'alliage 22 est une couche optionnelle mais avantageuse pour réduire les résistances de contact.

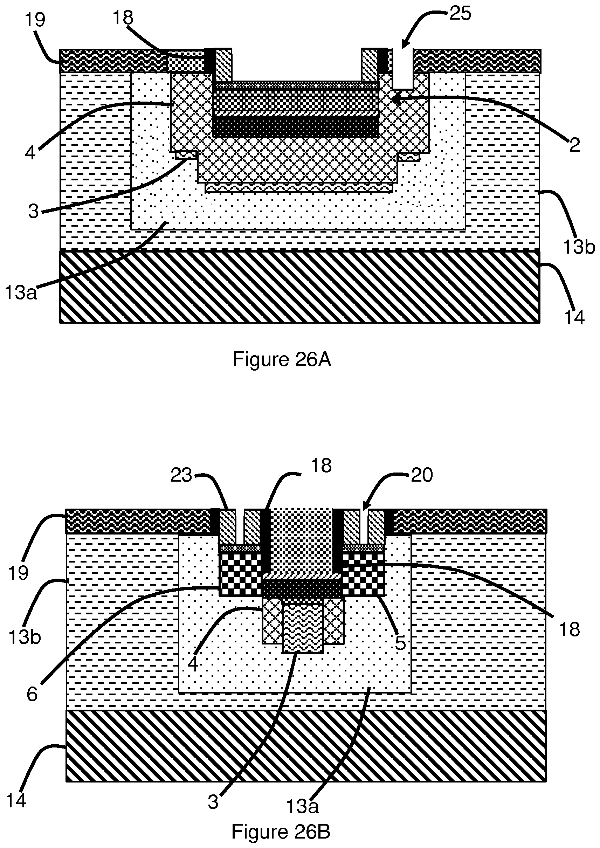

Comme illustré aux figures 26A et 26B, un trou 25 est formé de manière à atteindre le motif de grille 3, le trou 25 est au moins formé dans la couche 19.

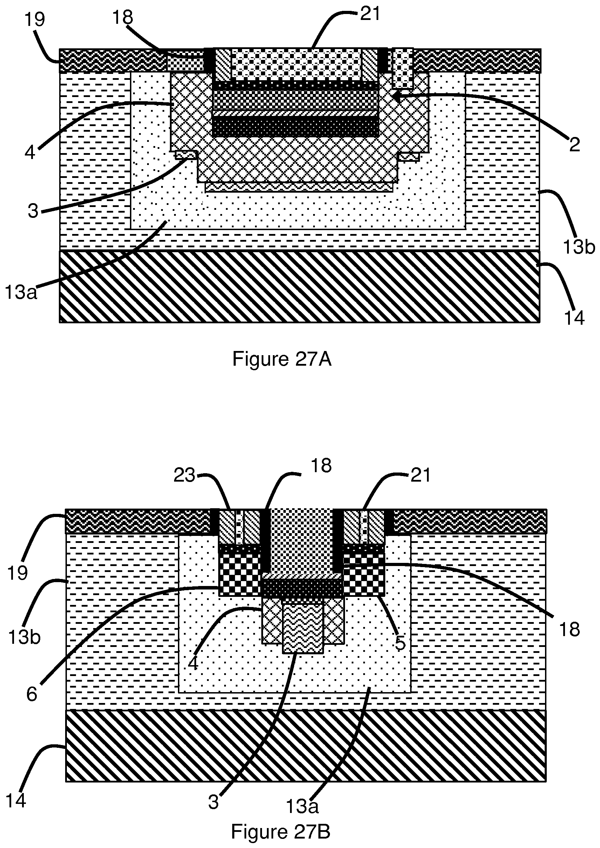

Comme illustré aux figures 27A et 27B, un matériau électriquement conducteur 21 est déposé de manière à remplir au moins partiellement les cavités formées dans la deuxième couche de couverture 19 au-dessus des zones de source 5 et de drain 6 dans les cavités 20. Le matériau conducteur 21 est avantageusement un métal.

Pour localiser le matériau électriquement conducteur 21 au-dessus des zones de source 5 et de drain 6, il est avantageux de réaliser une étape de polissage mécano-chimique qui s'arrête préférentiellement à la surface de la couche 19.

De manière avantageuse, le dépôt du matériau électriquement conducteur 21 est précédé par le dépôt d'un matériau barrière (non représenté) qui est configuré pour bloquer la diffusion de certains éléments et notamment l'oxygène. Le matériau barrière est électriquement conducteur. De manière préférentielle, le matériau électriquement conducteur 21 est un matériau métallique, par exemple du tungstène afin de réduire les résistances de contact.

Ces différents dépôts peuvent être suivis d'une étape de localisation par exemple par polissage mécano-chimique.

En variante, le matériau électriquement conducteur 21 est déposé de manière directionnelle, par exemple par pulvérisation, et localisé dans le fond des cavités formées par le retrait des motifs 17. La localisation peut être obtenue simplement au moyen d'une étape de polissage mécano-chimique.

Préférentiellement, la couche barrière est déposée de manière conforme, c'est-à-dire que l'épaisseur sur les parois verticales est identique à l'épaisseur sur les parois horizontales.

Si lors de la formation du trou 25, une des parois latérales est formée au moins en partie par le matériau 27 disposé au dessus du canal de conduction. Le contact à venir sera un contact commun au deux électrodes de grilles.

Pour avoir deux électrodes de grilles électriquement dissociées, il est possible de réaliser le trou 25 agencé de manière à ne pas venir en contact avec l'électrode de grille formée par le matériau conducteur 21 à l'intérieur de la couche 19.

En variante, le trou 25 formé pour atteindre le motif de grille 3 est réalisé après la gravure anisotrope de la couche barrière.

Comme dans le mode de réalisation précédent, si le motif de grille est une « fausse grille », ce dernier est retiré et remplacé par les matériaux adaptés à la formation d'une électrode de grille.

Pour éviter un court-circuit entre les électrodes de source 5 et de drain 6 avec la deuxième électrode de grille tout en restant compact, il est préférable de former un espaceur latéral additionnel 23 entre les électrodes. L'espaceur latéral additionnel 23 est réalisé dans un matériau électriquement isolant.

Dans les différents modes de réalisation, on peut remarquer que deux motifs de délimitation 17 sont formés de manière à recouvrir les zones de source 5 et de drain 6 et pour laisser libre le motif de partage 8. La deuxième couche de couverture 19 est ensuite déposée. Les première et deuxième couches de couverture 13a, 13b, 19 sont séparées par le motif en matériau semi-conducteur 2 sur au moins une partie. Les deux motifs de délimitation 17 sont éliminés pour former des trous d'accès 20 à la zone de source 5 et à la zone de drain 6. De cette manière, les futurs contacts de source et de drain sont délimités dès l'accès aux zones de source et de drain pour faciliter le positionnement des contacts.

Il est alors possible de former un transistor à double grille ou un transistor de type FDSOI avec une contre-électrode.

## Revendications

1. Procédé de réalisation d'un dispositif à effet de champ comportant successivement :
- prévoir un substrat (1) recouvert par
∘ un motif en matériau semi-conducteur (2) comportant une première couche en premier matériau semi-conducteur (9) recouvrant une deuxième couche en deuxième matériau semi-conducteur (10)
∘ un motif de grille (3) recouvrant le motif en matériau semi-conducteur (2),
- graver la première couche en premier matériau semi-conducteur (9) en utilisant le motif de grille (3) comme masque de gravure,
- graver la deuxième couche en deuxième matériau semi-conducteur (10) de manière à former une cavité et suspendre la première couche en premier matériau semi-conducteur (9),
- déposer un matériau de remplissage (12) de manière à remplir la cavité,
∘ graver le matériau de remplissage (12) en utilisant le motif de grille comme masque de gravure pour former un motif de partage (8),
∘ déposer un matériau semi-conducteur de manière à ce que le motif de partage (8) comporte au moins trois faces consécutives recouvertes par le motif en matériau semi-conducteur (2), le motif de grille (3) recouvrant le motif de partage (8) et définissant une zone de source (5), une zone de drain (6) et un canal de conduction dans le motif en matériau semi-conducteur (2),
- déposer une couche de couverture (13a, 13b) de manière à recouvrir le substrat (1), le motif en matériau semi-conducteur (2) et le motif de grille (3),
- éliminer le substrat (1, 15, 16) de manière à libérer une partie de la zone de source (5), de la zone de drain (6) et du motif de grille (3),
- former deux motifs de délimitation (17) recouvrant les zones de source (5) et de drain (6) et laissant libre le motif de partage (8),
- déposer une deuxième couche de couverture (19), les première et deuxième couches de couverture (13a, 13b, 19) étant séparées par le motif en matériau semi-conducteur (2) sur au moins une partie,
- éliminer les deux motifs de délimitation (17) pour former des trous d'accès (19) à la zone de source (5) et à la zone de drain (6).

2. Procédé selon la revendication 1, **caractérisé en ce que** les motifs de délimitation (17) sont formés par dépôt sélectif à partir des zones de source (5) et de drain (6).

3. Procédé selon la revendication 2, **caractérisé en ce qu'**il comporte une étape de polissage mécano-chimique de la deuxième couche de couverture (19) configurée pour libérer les motifs de délimitation (17).

4. Procédé selon l'une des revendications 1 à 3, **caractérisé en ce qu'**il comporte la formation d'espaceurs latéraux (18) sur les bords des motifs de délimitation (17).

5. Procédé selon l'une des revendications 1 à 3, **caractérisé en ce qu'**il comporte la formation d'espaceurs latéraux (23) sur les bords de la deuxième couche de couverture (19) après élimination des motifs de délimitation (17).

6. Procédé selon la revendication 4, **caractérisé en ce qu'**il comporte la formation d'espaceurs latéraux additionnels (23) sur les bords des espaceurs latéraux (21) après élimination des motifs de délimitation (17).

7. Procédé selon la revendication 6, **caractérisé en ce qu'**il comporte la formation d'un alliage entre un métal (21) et un matériau semi-conducteur formant les zones de source et de drain (5, 6) et **en ce que** les espaceurs latéraux additionnels (23) sont réalisés après la formation de l'alliage (22).

8. Procédé selon l'une quelconque des revendications 1 à 7, **caractérisé en ce qu'**il comporte une gravure partielle du motif de partage (8).

9. Procédé selon l'une des revendications 1 à 8, **caractérisé en ce qu'**il comporte successivement :
- l'élimination du motif de partage (8),
- la formation d'un diélectrique de grille (26),
- le dépôt d'un matériau électriquement conducteur (27) entre les deux motifs de délimitation (17) pour former une électrode de grille.

10. Procédé selon les revendications 4 et 9, dans lequel l'espaceur latéral (18) comporte au moins une couche en matériau ayant une constante diélectrique inférieure à celle de l'oxyde de silicium.

11. Procédé selon l'une des revendications 9 et 10, comportant une étape de polissage mécano-chimique pour localiser le matériau électriquement conducteur (27) entre les deux motifs de délimitation (17).

12. Procédé selon l'une des revendications 9 à 11, dans lequel le diélectrique de grille (26) est déposé sur les motifs de délimitation (17) avant le dépôt du matériau électriquement conducteur (27).

13. Procédé selon l'une des revendications 1 à 12, comportant en plus une étape d'épitaxie sélective de manière à former les zones de source (5) et de drain (6) après formation du motif de partage (8).

14. Procédé selon la revendication 13, dans lequel le substrat est recouvert par un motif en matériau semi-conducteur (2) comportant successivement une première couche en premier matériau semi-conducteur (9), une deuxième couche en deuxième matériau semi-conducteur (10) et une troisième couche en troisième matériau semi-conducteur (11) et dans lequel, les gravures de la deuxième couche (10) et du matériau de remplissage (12) sont configurées pour sauvegarder au moins une partie de la troisième couche (11) de manière à permettre la formation des zones de source (5) et de drain (6) depuis la troisième couche (11) lors de l'étape d'épitaxie sélective.

15. Procédé selon l'une quelconque des revendications 1 à 14, **caractérisé en ce que** le motif de partage (8) est réalisé dans un matériau électriquement isolant et **en ce qu'**il comporte, après élimination du substrat (1), le dépôt d'un matériau métallique et son recuit pour former un alliage (22) entre le matériau métallique et un matériau semi-conducteur formant les zones de source et/ou de drain.

## Patentansprüche

1. Herstellungsverfahren eines Feldeffekttransistors, mit den aufeinanderfolgenden Schritten:
- Vorsehen eines Substrates (1), das von
• einem Muster aus Halbleitermaterial (2) mit einer ersten Schicht aus einem ersten Halbleitermaterial (9), das eine zweite Schicht aus einem zweiten Halbleitermaterial (10) bedeckt,
• einem Gittermuster (3), das das Muster aus Halbleitermaterial (2) bedeckt, bedeckt ist,
- Gravieren der ersten Schicht aus einem ersten Halbleitermaterial (9), indem das Gittermuster (3) als Graviermaske eingesetzt wird,
- Gravieren der zweiten Schicht aus einem zweiten Halbleitermaterial (10) derart, dass ein Hohlraum gebildet wird und die erste Schicht aus dem ersten Halbleitermaterial (9) aufgehängt wird,
- Anordnen eines Füllmaterials (12), um den Hohlraum auszufüllen,
• Gravieren des Füllmaterials (12), indem das Gittermuster als Graviermaske zur Bildung eines Teilungsmusters (8) eingesetzt wird,
• Anordnen eines Halbleitermaterials derart, dass das Teilungsmuster (8) mindestens drei aufeinanderfolgende, mit dem Muster aus Halbleitermaterial (2) bedeckte Flächen aufweist, wobei das Gittermuster (3) das Teilungsmuster (8) bedeckt und einen Quellenbereich (5), einen Abflussbereich (6) und einen Leitungskanal in dem Muster aus Halbleitermaterial (2) festlegt,
- Anordnen einer Deckschicht (13a, 13b), um das Substrat (1), das Muster aus Halbleitermaterial (2) und das Gittermuster (3) zu bedecken,
- Entfernen des Substrats (1, 15, 16), um einen Teil des Quellenbereiches (5), des Abflussbereiches (6) und des Gittermusters (3) freizulegen,
- Ausbilden von zwei Abgrenzungsmustern (17), die den Quellenbereich (5) und den Abflussbereich (6) bedecken und das Teilungsmuster (8) freilassen,
- Anordnen einer zweiten Deckschicht (19), wobei die erste und zweite Deckschicht (13a, 13b, 19) durch das Muster aus Halbleitermaterial (2) auf mindestens einem Teil getrennt sind,
- Entfernen der zwei Abgrenzungsmuster (17), um Zugangsöffnungen (19) zu dem Quellenbereich (5) und dem Abflussbereich (6) zu bilden.

2. Verfahren nach Anspruch 1, **dadurch gekennzeichnet, dass** die Abgrenzungsmuster (17) durch wahlweise Ablage ab dem Quellen- (5) und dem Abflussbereich (6) gebildet sind.

3. Verfahren nach Anspruch 2, **dadurch gekennzeichnet, dass** es einen mechanisch-chemischen Polierschritt der zweiten Deckschicht (19) umfasst, die zur Freisetzung der Abgrenzungsmuster (17) ausgeführt ist.

4. Verfahren nach einem der Ansprüche 1 bis 3, **dadurch gekennzeichnet, dass** es die Bildung seitlicher Abstandshalter (18) an den Rändern der Abgrenzungsmuster (17) umfasst.

5. Verfahren nach einem der Ansprüche 1 bis 3, **dadurch gekennzeichnet, dass** es die Bildung seitlicher Abstandshalter (23) an den Rändern der zweiten Deckschicht (19) nach Entfernung der Abgrenzungsmuster (17) umfasst.

6. Verfahren nach Anspruch 4, **dadurch gekennzeichnet, dass** es die Bildung von zusätzlichen seitlichen Abstandshaltern (23) an den Rändern der seitlichen Abstandshalter (21) nach Entfernung der Abgrenzungsmuster (17) umfasst.

7. Verfahren nach Anspruch 6, **dadurch gekennzeichnet, dass** es die Bildung einer Legierung zwischen einem Metall (21) und einem Halbleitermaterial umfasst, die die Quellen- und Abflussbereiche (5, 6) bildet, und dass die zusätzlichen seitlichen Abstandshalter (23) nach der Bildung der Legierung (22) hergestellt werden.

8. Verfahren nach einem der Ansprüche 1 bis 7, **dadurch gekennzeichnet, dass** es eine teilweise Gravierung des Teilungsmusters (8) umfasst.

9. Verfahren nach einem der Ansprüche 1 bis 8, **dadurch gekennzeichnet, dass** es aufeinanderfolgend:
- die Entfernung des Teilungsmusters (8),
- die Ausbildung eines Gitter-Dielektrikums (26),
- die Ablage eines elektrisch leitenden Materials (27) zwischen den beiden Abgrenzungsmustern (17) zur Ausbildung einer Gitterelektrode umfasst.

10. Verfahren nach den Ansprüchen 4 und 9, bei dem der seitliche Abstandshalter (18) mindestens eine Schicht aus einem Material mit einer Dielektrizitätszahl umfasst, die niedriger als die des Siliziumoxids ist.

11. Verfahren nach einem der Ansprüche 9 und 10, mit einem mechanisch-chemischen Polierschritt, um das elektrisch leitende Material (27) zwischen den beiden Abgrenzungsmustern (17) einzugrenzen.

12. Verfahren nach einem der Ansprüche 9 bis 11, bei dem das Gitter-Dielektrikum (26) vor der Ablagerung des elektrisch leitenden Materials (27) auf den Abgrenzungsmustern (17) angeordnet wird.

13. Verfahren nach einem der Ansprüche 1 bis 12, weiterhin mit einem selektiven Epitaxieschritt, um den Quellenbereich (5) und den Abflussbereich (6) nach der Bildung des Teilungsmusters (8) auszubilden.

14. Verfahren nach Anspruch 13, bei dem das Substrat von einem Muster aus einem Halbleitermaterial (2) bedeckt ist, das aufeinanderfolgend eine erste Schicht aus einem ersten Halbleitermaterial (9), eine zweite Schicht aus einem zweiten Halbleitermaterial (10) und eine dritte Schicht aus einem dritten Halbleitermaterial (11) aufweist, und bei dem die Gravierungen der zweiten Schicht (10) und des Füllmaterials (12) zum Schutz von mindestens einem Teil der dritten Schicht (11) derart ausgeführt sind, dass sie die Bildung des Quellenbereiches (5) und des Abflussbereiches (6) von der dritten Schicht (11) aus während des selektiven Epitaxieschrittes ermöglichen.

15. Verfahren nach einem der Ansprüche 1 bis 14, **dadurch gekennzeichnet, dass** das Teilungsmuster (8) in einem elektrisch isolierenden Material ausgeführt ist, und dass es nach Entfernung des Substrates (1) die Ablagerung eines metallischen Materials und dessen Ausglühen umfasst, um eine Legierung (22) zwischen dem metallischen Material und einem Halbleitermaterial zu bilden, die den Quellen- und/oder Abflussbereich bildet.

## Claims

1. Method for fabricating a field effect device successively comprising:
- providing a substrate (1) covered by
∘ a semiconductor material pattern (2) comprising a first layer made from first semiconductor material (9) covering a second layer made from second semiconductor material (10),
∘ a gate pattern (3) covering the semiconductor material pattern (2),
- etching the first layer of first semiconductor material (9) using the gate pattern (3) as etch mask,
- etching the second layer of second semiconductor material (10) so as to form a cavity and to suspend the first layer of first semiconductor material (9),
- depositing a filling material (12) so as to fill the cavity,
∘ etching the filling material (12) using the gate pattern as etch mask to form a dividing pattern (8),
∘ depositing a semiconductor material so that the dividing pattern (8) comprises at least three consecutive faces covered by the semiconductor material pattern (2), the gate pattern (3) covering the dividing pattern (8) and defining a source region (5), a drain region (6) and a conduction channel in the semiconductor material pattern (2),
- depositing a cap layer (13a, 13b) so as to cover the substrate (1), the semiconductor material pattern (2) and the gate pattern (3),
- eliminating the substrate (1, 15, 16) so as to release a part of the source region (5), drain region (6) and gate pattern (3),
- forming two delineation patterns (17) covering the source (5) and drain (6) regions and leaving the dividing pattern (8) free,
- depositing a second cap layer (19), the first and second cap layers (13a, 13b, 19) being separated by the semiconductor material pattern (2) over at least a part thereof,
- eliminating the two delineation patterns (17) to form access vias (19) to the source region (5) and drain region (6).

2. Method according to claim 1, **characterized in that** the delineation patterns (17) are formed by selective deposition from the source (5) and drain (6) regions.

3. Method according to claim 2, **characterized in that** it comprises a chemical mechanical polishing step of the second cap layer (19) configured to release the delineation patterns (17).

4. Method according to one of claims 1 to 3, **characterized in that** it comprises the formation of lateral spacers (18) on the edges of the delineation patterns (17).

5. Method according to one of claims 1 to 3, **characterized in that** it comprises the formation of lateral spacers (23) on the edges of the second cap layer (19) after elimination of the delineation patterns (17).

6. Method according to claim 4, **characterized in that** it comprises the formation of additional lateral spacers (23) on the edges of the lateral spacers (21) after elimination of the delineation patterns (17).

7. Method according to claim 6, **characterized in that** it comprises the formation of an alloy between a metal (21) and a semiconductor material forming the source and drain regions (5, 6) and **in that** the additional lateral spacers (23) are made after the formation of the alloy (22).

8. Method according to any one of claims 1 to 7, **characterized in that** it comprises a partial etching of the dividing pattern (8).

9. Method according to one of claims 1 to 8, **characterized in that** it successively comprises:
- elimination of the dividing pattern (8),
- the formation of a gate dielectric (26),
- the deposition of an electrically conducting material (27) between the two delineation patterns (17) to form a gate electrode.

10. Method according to claims 4 and 9, wherein the lateral spacer (18) comprises at least a layer made from material having a dielectric constant lower than that of silicon oxide.

11. Method according to one of claims 9 and 10, comprising a chemical mechanical polishing step to localise the electrically conducting material (27) between the two delineation patterns (17).

12. Method according to one of claims 9 to 11, wherein the gate dielectric (26) is deposited on the delineation patterns (17) before the deposition of the electrically conducting material (27).

13. Method according to one of claims 1 to 12, further comprising a selective epitaxy step so as to form the source (5) and drain (6) regions after formation of the dividing pattern (8).

14. Method according to claim 13, wherein the substrate is covered by a semiconductor material pattern (2) successively comprising a first layer made from first semiconductor material (9), a second layer made from second semiconductor material (10) and a third layer made from third semiconductor material (11), and wherein, the etches of the second layer (10) and of the filling material (12) are configured to preserve at least a part of the third layer (11) so as to enable the formation of the source (5) and drain (6) regions from the third layer (11) during the selective epitaxy step.

15. Method according to any one of claims 1 to 14, **characterized in that** the dividing pattern (8) is made from an electrically insulating material and **in that** it comprises, after elimination of the substrate (1), the deposition of a metallic material and annealing of the latter to form an alloy (22) between the metallic material and a semiconductor material forming the source and/or drain regions.
